# EUROPEAN PATENT SPECIFICATION

(11) **EP 4 101 641 B1**
(45) Date of publication and mention of the grant of the patent: **09.10.2024**
(21) Application number: 22178258.4
(22) Date of filing: 09.06.2022
(51) Int. Cl.: C08G 65/22, C08G 65/00, C08G 65/336, C09D 171/00, H10K 77/10, C08J 5/18, C08G 69/42, C08G 73/14, C08J 7/043, C08J 7/046, C08L 79/08, C08G 73/10

(54) **WINDOW COVER FILM, METHOD OF MANUFACTURING THE SAME, AND FLEXIBLE DISPLAY PANEL INCLUDING THE SAME**
FENSTERABDECKFOLIE, VERFAHREN ZU IHRER HERSTELLUNG UND FLEXIBLE ANZEIGETAFEL DAMIT
FILM DE COUVERTURE DE FENÊTRE, SON PROCÉDÉ DE FABRICATION ET PANNEAU D'AFFICHAGE SOUPLE LE COMPRENANT

(30) Priority: 10.06.2021 KR 20210075178
(43) Date of publication of application: 14.12.2022
(73) Proprietor: SK Innovation Co., Ltd., Seoul 03188 (KR); SK ie technology Co., Ltd., Jongno-gu Seoul 03188 (KR)
(72) Inventor: CHOI, Jeong Min, 34124 Daejeon (KR); KANG, Seong Wook, 34124 Daejeon (KR); KO, Keon Hyeok, 34124 Daejeon (KR); YI, Hwan Pyo, 34124 Daejeon (KR)
(74) Representative: Stolmár & Partner Patentanwälte PartG mbB

(56) References cited:
- KR-A- 20200 070 511
- US-A1- 2019 033 494
- US-A1- 2020 056 056
- US-A1- 2021 072 427
- US-A1- 2021 094 265
- DATABASE WPI Week 202005, 18 June 2020 Derwent World Patents Index; AN 2020-554647, XP002807771

## Description

### TECHNICAL FIELD

The following disclosure relates to a window cover film, a method of manufacturing the same, and a flexible display panel including the same.

### BACKGROUND

Recently, thin display devices using a flat panel display device such as a liquid crystal display device or an organic light emitting diode display device are drawing a lot of attention. In particular, these thin displays are implemented in the form of a touch screen panel, and are widely used in various smart devices characterized by their portability including various wearable devices as well as smart phones and tablet PCs.

These portable touch screen panel-based displays are provided with a window cover for display protection on a display panel in order to protect the display panel from scratches or external impact, and in most cases, a tempered glass for a display is used as a window cover. The tempered glass for a display is thinner than a regular glass, but is characterized by being manufactured to have scratch resistance with high strength. However, the tempered glass is unsuitable for weight reduction of portable devices due to its heavy weight, is vulnerable to external shock so that it is difficult to implement a characteristic of not being easily broken, and does not bend beyond a certain level so that the tempered glass is unsuitable as a flexible display material having a bendable or foldable function.

Recently, various studies on an optical plastic cover securing flexibility and impact resistance while also having strength or scratch resistance corresponding to tempered glass have been conducted. In general, an example of optical transparent plastic cover base materials having flexibility as compared with tempered glass may include polyethylene terephthalate (PET), polyether sulfone (PES), polyethylene naphthalate (PEN), polyacrylate (PAR), polycarbonate (PC), polyimide (PI), polyaramid (PA), and polyamideimide (PAI). However, these polymer plastic base materials show insufficient physical properties in terms of hardness and scratch resistance and also have insufficient impact resistance, as compared with a tempered glass used as a window cover for display protection. Thus, various attempts for complementing the required physical properties by coating these plastic base materials with a composite resin composition, have been made. Exemplary coating or cover films are disclosed in US 2021/072427 A1, US 2019/033494 A1, KR 2020 0070511 A, US 2021/094265 A1 and US 2020/056056 A1.

In particular, in recent years, a plurality of window cover films on which a hard coating layer is provided for complementing insufficient physical properties of the optical transparent plastic base material and an antifouling layer formed of a hydrophobic material having fluorine and silicon elements is formed thereon are known in the art. However, the window cover films also have a poor binding force due to the low surface energy of the hydrophobic material, so that the films are easily damaged by external abrasion and the physical properties such as stain resistance and scratch resistance are still easily deteriorated.

Accordingly, development of a new window cover film, which is not easily damaged even by exposure to abrasion, vibration, compounds, and the like, maintains physical properties such as wear resistance and scratch resistance for a long time to maintain excellent properties while also having excellent sense of tough and slip properties, and is appropriate for complementing insufficient physical properties of the optical transparent plastic base material, is needed.

### SUMMARY

An embodiment is directed to providing a window cover film having excellent interlayer binding force and significantly improved wear resistance, scratch resistance, and fingerprint wipeability, and a flexible display panel including the same. Another embodiment is directed to providing a window cover film having an effect of having excellent antifouling properties even after exposure to abrasion, vibration, and compounds for a long time, for example, satisfying a water contact angle of 90° or more even after long-term wear resistance evaluation and having excellent wear resistance.

Another embodiment is directed to providing a window cover film having a glass-like sense of touch and surface properties of excellent slip properties.

Another embodiment is directed to providing a window cover film having excellent scratch resistance and fingerprint wipeability and being capable of minimizing damage or staining of an appearance of a film surface.

Still another embodiment is directed to providing a method of manufacturing a window cover film having an excellent interlayer binding force and significantly improved wear resistance, scratch resistance, and fingerprint wipeability.

According to the present invention, a window cover film includes: a substrate layer;
a hard coating layer formed on one surface of the substrate layer;
an adhesion enhancement layer formed from a composition for forming an adhesion enhancement layer comprising an alkoxysilane compound having one or two or more functional groups, formed on the hard coating layer; and
an antifouling layer formed from a composition for forming an antifouling layer comprising a fluorine-containing alkoxysilane compound, formed on the adhesion enhancement layer.

In an implementation, the functional group may be an organofunctional group, preferably, the organofunctional group may be any one selected from a carboxyl group, an epoxy group, a mercapto group, an isocyanate group, and an amino group, or a combination thereof.

In an implementation, the fluorine-containing alkoxysilane compound may have a perfluoropolyether group in a molecular main chain and a hydrolysable group bonded to a terminal silicon.

In an implementation, the window cover film may have a water contact angle of 90° or more in accordance with ASTM D5946 after evaluating wear resistance by rubbing 1500 times at a speed of 40 rpm against the surface of the window cover film at a distance of 20 mm with a load of 0.5 kg on a rubber stick (minoan) of a diameter of 6mm. In one embodiment, the film may have a coefficient of dynamic friction of less than 0.15, as measured by rubbing a dust-free cloth with a force of 5 N with a load of 200 g at a speed of 100 mm/min.

In an implementation, the hard coating layer may be formed from a composition for forming a hard coating layer comprising a condensate of an alkoxysilane having an epoxy group.

In an implementation, the condensate of an alkoxysilane having an epoxy group may be a silsesquioxane resin having an epoxy group.

In an implementation, the hard coating layer may be formed from a composition for forming a hard coating layer comprising a crosslinking agent having a polyfunctional epoxy group.

In an implementation, the substrate layer may be a polyimide-based substrate layer including a unit derived from a fluorine-containing aromatic diamine, preferably the substrate layer may be a polyimide-based substrate layer including a unit derived from a fluorine-containing aromatic diamine, a unit derived from an aromatic dianhydride, and a unit derived from an aromatic diacid dichloride, preferably, the polyimide-based substrate layer may further include a unit derived from a cycloaliphatic dianhydride.

In an implementation, the substrate layer may have a thickness of 10 to 150 µm.

In an implementation, the hard coating layer may have a thickness of 1 to 100 µm.

In an implementation, the antifouling layer may have a thickness of 1 to 100 nm.

In an implementation, the adhesion enhancement layer may have a thickness of 1 to 300 nm.

The present invention further provides a method of manufacturing a window cover film includes: applying a composition for forming a hard coating layer on one surface of a substrate layer and curing the composition to form a hard coating layer;
applying a composition for forming an adhesion enhancement layer including an alkoxysilane compound having one or two or more functional groups on the hard coating layer and drying the composition to form an adhesion enhancement layer; and
applying a composition for forming an antifouling layer including a fluorine-containing alkoxysilane compound on the adhesion enhancement layer and curing the composition to form an antifouling layer.

In an implementation, the functional group may be an organofunctional group, preferably the organofunctional group may be any one selected from a carboxyl group, an epoxy group, a mercapto group, an isocyanate group, and an amino group, or a combination thereof.

In an implementation, the fluorine-containing alkoxysilane compound may have a perfluoropolyether group in a molecular main chain and a hydrolysable group bonded to a terminal silicon.

In an implementation, the composition for forming a hard coating layer may include a condensate of an alkoxysilane having an epoxy group, preferably, the condensate of an alkoxysilane having an epoxy group may be a silsesquioxane resin having an epoxy group, preferably the composition for forming a hard coating layer may further include a crosslinking agent having a polyfunctional epoxy group.

The present invention further provides a flexible display panel includes the window cover film described above.

Other features and aspects will be apparent from the following detailed description, the drawings, and the claims.

### DETAILED DESCRIPTION OF EMBODIMENTS

Hereinafter, a window cover film according to an implementation, a method of manufacturing the same, and a flexible display panel including the same will be described in detail.

Herein, unless otherwise defined, all technical terms and scientific terms have the same meanings as those commonly understood by one of those skilled in the art disclosed in the present specification. The terms used in the description of the present specification are only for effectively describing certain specific examples, and are not intended to limit the implementation. Further, unless otherwise stated, the unit of added materials herein may be wt%.

In addition, the singular form used in the specification and claims appended thereto may be intended to also include a plural form, unless otherwise indicated in the context.

Throughout the present specification, unless explicitly described to the contrary, "comprising" any constituent elements will be understood to imply further inclusion of other constituent elements rather than the exclusion of any other constituent elements.

Hereinafter, unless otherwise defined in the present specification, it will be understood that when a part such as a layer, a film, a thin film, a region, or a plate is referred to as being "on" or "above" another part, it may include not only the case of being "directly on" the other part but also the case of having an intervening part therebetween.

Hereinafter, unless otherwise defined in the present specification, a "combination thereof" refers to a mixture or copolymerization of constituents.

Hereinafter, unless otherwise particularly defined in the present specification, the term "A and/or B" may refer to an embodiment including both A and B or an embodiment selecting one of A and B.

Hereinafter, unless otherwise particularly defined in the present specification, the term "derived" means a form in which at least any one of the functional groups of a compound is modified, and specifically, a reacting group and/or a leaving group of a compound is/are modified or left by the reaction. In addition, when structures derived from different compounds are the same, a structure derived from any one compound may also include a case of being derived from any other compound to have the same structure.

Hereinafter, unless otherwise particularly defined in the present specification, a "polymer" refers to a molecule which has a relatively high molecular weight and the structure may include multiple repetitions of a unit derived from a low molecular weight molecule. In an embodiment, the polymer may be an alternating copolymer, a block copolymer, a random copolymer, a branched copolymer, a crosslinked copolymer, or a copolymer including all of them (for example, a copolymer including more than one monomer). In another embodiment, the polymer may be a homopolymer (for example, a copolymer including one monomer). Hereinafter, unless otherwise particularly defined in the present specification, the term "flexible" may refer to being bent, warped, or folded.

Hereinafter, unless otherwise particularly defined in the present specification, "polyimide" includes an imide structure, and may be used in the meaning of including "polyimide" or "polyamideimide".

In an implementation, a window cover film which includes an antifouling layer formed of a hydrophobic material having fluorine and silicon elements, but is not easily damaged even by exposure to abrasion, vibration, and compounds, and has excellent scratch resistance, and fingerprint wipeability, and a flexible display panel including the same may be provided.

The window cover film according to an embodiment may include: a substrate layer;
a hard coating layer formed on one surface of the substrate layer;
an adhesion enhancement layer formed from a composition for forming an adhesion enhancement layer comprising an alkoxysilane compound having one or two or more functional groups, formed on the hard coating layer; and
an antifouling layer formed from a composition for forming an antifouling layer layer comprising a fluorine-containing alkoxysilane compound, formed on the adhesion enhancement layer. In an implementation, the "alkoxysilane compound" may refer to a compound including an alkoxysilane group, a unit derived from the alkoxysilane compound, or an alkoxysilane compound.

Here, the substrate layer, the hard coating layer, the adhesion enhancement layer, and the antifouling layer may be laminated in order. In addition, each layer may be laminated directly in contact with each other, and another layer may be formed between layers, respectively.

The window cover film according to an embodiment has significantly improved wear resistance, and may have a water contact angle of 90° or more in accordance with ASTM D5946 after evaluating wear resistance by rubbing 1500 times at a speed of 40 rpm against the surface of the window cover film at a distance of 20 mm with a load of 0.5 kg on a rubber stick (minoan) of a diameter of 6mm, but is not necessarily limited thereto.

In addition, the window cover film according to an embodiment may have a coefficient of dynamic friction of less than 0.15, as measured by rubbing a dust-free cloth with a force of 5 N with a load of 200 g at a speed of 100 mm/min, but is not necessarily limited thereto.

In addition, the window cover film according to an embodiment has significantly improved scratch resistance, so that no damage is shown on a film surface even after the surface is rubbed 1000 times reciprocatingly with steel wool with a load of 0.5 kg applied, and has significantly improved fingerprint wipeability, so that as a result of attaching a fingerprint on the surface of the antifouling layer of the film, wiping the surface with a dust-free cloth, and measuring the number of wipes until no fingerprint is observed, the number is less than 5 or 3 or less, but is not necessarily limited thereto.

Hereinafter, each component of a substrate layer, a hard coating layer, an antifouling layer, and adhesion enhancement layer included in the window cover film according to an embodiment will be described in more detail. However, these are only illustrative and an implementation is not limited to the specific embodiments which are illustratively described.

### <Substrate layer>

First, a substrate layer according to an embodiment will be described.

It is preferred that the substrate layer according to an embodiment has transparency, mechanical strength, thermal stability, moisture shielding properties, isotropy, and the like which are excellent. The substrate layer may be manufactured from, for example, polyester-based resins such as polyethylene terephthalate, polyethylene isophthalate, and polybutylene terephthalate; cellulose-based resins such as diacetyl cellulose and triacetyl cellulose; polycarbonate-based resins; acrylic resins such as polymethyl (meth)acrylate and polyethyl (meth)acrylate; styrene-based resins such as a polystyrene acrylonitrile-styrene copolymer; polyolefin-based resins having a polyethylene, polypropylene, cyclo-based, or norbornene structure; polyolefin-based resins such as an ethylene propylene copolymer; polyimide-based resins; polyaramid-based resins; polyethersulfone-based resins; and sulfone-based resins; and these resins may be used alone or in combination of two or more, but the present disclosure is not necessarily limited thereto. More specifically, in an embodiment, the substrate layer may be a polyimide-based substrate layer formed of a polyimide-based resin including a unit derived from a fluorine-containing aromatic diamine, in which the polyimide-based resin may include both a polyimide resin and a polyamideimide resin.

Therefore, in an embodiment, the polyimide-based substrate layer includes a polyamideimide resin including a fluorine atom and an aliphatic cyclic structure, and as a specific example, may be a polyimide-based substrate layer including a unit derived from a fluorine-containing aromatic diamine, an aromatic dianhydride, and an aromatic diacid dichloride, and as a more specific example, a polyimide-based substrate layer further including a unit derived from a cycloaliphatic dianhydride, but is not necessarily limited thereto.

When the substrate layer is a polyimide-based substrate layer, a rainbow phenomenon or a mura phenomenon does not occur, a film having better optical properties may be provided, the haze of the window cover film is lowered, a total light transmittance may be increased, and a film having better transparency may be provided, and thus, the polyimide-based substrate layer is preferred, but the present disclosure is not necessarily limited thereto.

The thickness of the substrate layer is not particularly limited, and for example, may be 10 to 150 µm.

### <Hard coating layer>

Next, the hard coating layer according to an embodiment will be described.

In an embodiment, the hard coating layer may be formed on one surface of the substrate layer. The hard coating layer may protect the substrate layer having excellent optical and mechanical properties from external physical and chemical damage. In an embodiment, the hard coating layer may be formed by curing a composition for forming a hard coating layer, and also, may be a composite hard coating layer obtained by photocuring and then thermally curing the composition for forming a hard coating layer, but is not necessarily limited thereto.

In an embodiment, the hard coating layer may be formed from a composition for forming a hard coating layer comprising a condensate of an alkoxysilane having an epoxy group, and for example, the condensate of an alkoxysilane having an epoxy group may be a siloxane resin including an epoxy group, but the present disclosure is not necessarily limited thereto. The condensate of an alkoxysilane having an epoxy group may have excellent hardness and bending properties when cured.

The epoxy group may be any one or more selected from a cyclic epoxy group, an aliphatic epoxy group, and an aromatic epoxy group, and the siloxane resin may refer to a polymer compound in which a silicon atom and an oxygen atom form a covalent bond.

In an embodiment, the condensate of an alkoxysilane having an epoxy group may be a silsesquioxane resin having an epoxy group, specifically, a silsesquioxane resin in which a silicon atom is directly substituted with an epoxy group or a substituent of the silicon atom is substituted with an epoxy group, and more specifically, the condensate of an alkoxysilane having an epoxy group may be a silsesquioxane resin substituted with 2-(3,4-epoxycyclohexyl)ethyl group, but is not necessarily limited thereto.

When an adhesion enhancement layer including an alkoxysilane compound having one or two or more functional groups is formed on the hard coating layer formed from a composition for forming a hard coating layer comprising a condensate of an alkoxysilane having an epoxy group, due to the similar chemical structure of the condensate of an alkoxysilane having an epoxy group and the alkoxysilane compound having one or two or more functional groups, a chemical bonding is formed between the epoxy group and the functional group, and the interlayer binding force between the hard coating layer and the adhesion enhancement layer may be further improved.

In an embodiment, the condensate of an alkoxysilane having an epoxy group may have a weight average molecular weight of 1,000 to 20,000 g/mol, specifically 1,000 to 18,000 g/mol, and more specifically 2,000 to 15,000 g/mol. When the weight average molecular weight is in the range described above, flowability, coatability, and curing reactivity of the composition for forming a hard coating layer may be further improved.

In an embodiment, the condensate of an alkoxysilane having an epoxy group may include a repeating unit derived from an alkoxysilane compound represented by the following Chemical Formula 1:

[Chemical Formula 1] R¹ₙSi(OR²)₄₋ₙ

wherein R¹ is a linear or branched alkyl group having 1 to 6 carbon atoms substituted with an epoxycycloalkyl group having 3 to 6 carbon atoms or an oxiranyl group, in which the alkyl group may include an ether group, R² is a linear or branched alkyl group having 1 to 7 carbon atoms, and n is an integer of 1 to 3. The alkoxysilane compound represented by Chemical Formula 1 may be, for example, 2-(3,4-epoxycyclohexyl)ethyltrimethoxysilane, 2-(3,4-epoxycyclohexyl)ethyltriethoxysilane, and 3-glycidoxypropyltrimethoxysilane, and may be used alone or in combination of two or more, but is not necessarily limited thereto.

In an embodiment, the condensate of an alkoxysilane having an epoxy group may be included at 20 to 70 parts by weight, specifically 20 to 50 parts by weight with respect to 100 parts by weight of the composition for forming a hard coating layer, but is not necessarily limited thereof. When the above range is satisfied, the composition for forming a hard coating layer may secure better flowability and applicability. In addition, uniform curing is allowed at the time of curing the composition for forming a hard coating layer, so that physical defects such as cracks due to overcuring may be more effectively prevented, and the hard coating layer may show better hardness.

In addition, in an embodiment, the hard coating layer may be formed from a composition for forming a hard coating layer further comprising a crosslinking agent having a polyfunctional epoxy group. Here, the crosslinking agent may include a compound having an alicyclic epoxy group, and for example, the crosslinking agent may include a compound having two 3,4-epoxycyclohexyl groups bonded, but is not necessarily limited thereto. The crosslinking agent may have a similar structure and a similar nature to the condensate of an alkoxysilane having an epoxy group, and in this case, may promote crosslinking of the condensate of an alkoxysilane having an epoxy group.

In an embodiment, the hard coating layer may have a thickness of 1 to 100 µm, more specifically 1 to 50 µm, but is not necessarily limited thereto. When the thickness of the hard coating layer is within the range, the hard coating layer may maintain flexibility while having better hardness, and may have further improved mechanical properties.

Hereinafter, a method of forming a hard coating layer will be described.

The hard coating layer is formed by preparing a composition for forming a hard coating layer, applying the composition on the substrate layer, and curing the composition.

In an embodiment, the composition for forming a hard coating layer may include a condensate of an alkoxysilane having an epoxy group, in which the condensate of an alkoxysilane having an epoxy group may be those as described above for the hard coating layer.

In addition, in an embodiment, the composition for forming a hard coating layer may further include a photoinitiator and a thermal initiator including a compound represented by the following Chemical Formula 2: 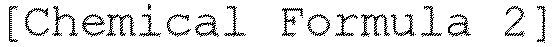 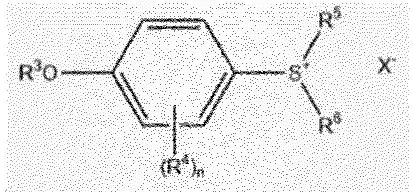 wherein R³ is hydrogen, an alkoxycarbonyl group having 1 to 4 carbon atoms, an alkylcarbonyl group having 1 to 4 carbon atoms, or an arylcarbonyl group having 6 to 14 carbon atoms, R⁴ is independently of each other hydrogen, halogen, or an alkyl group having 1 to 4 carbon atoms, n is 1 to 4, R⁵ is an alkyl group having 1 to 4 carbon atoms or an aralkyl group having 7 to 15 carbon atoms which may be substituted by an alkyl group having 1 to 4 carbon atoms, R⁶ is an alkyl group having 1 to 4 carbon atoms, and X is SbF₆, PF₆, AsF₆, BF₄, CF₃SO₃, N(CF₃SO₂)₂, or N(C₆F₅)₄.

The alkoxy portion of the alkoxycarbonyl group has 1 to 4 carbon atoms, and an example of the alkoxycarbonyl group may include a methoxycarbonyl group, an ethoxycarbonyl group, and a propoxycarbonyl group.

The alkyl portion of the alkylcarbonyl group has 1 to 4 carbon atoms, and an example of the alkylcarbonyl group may include an acetyl group, and a propionyl group.

The aryl portion of the arylcarbonyl group has 6 to 14 carbon atoms, and an example of the arylcarbonyl group may include a benzoyl group, a 1-naphthylcarbonyl group, and a 2-naphthylcarbonyl group.

An example of the aralkyl group may include a benzyl group, a 2-phenylethyl group, a 1-naphthylmethyl group, and a 2-naphthylmethyl group.

By using the compound of Chemical Formula 2 as a thermal initiator, a cure half-life may be shortened and thermal curing may be rapidly performed even in low-temperature conditions, and thus, damage and deformation due to a long-term heat treatment under high-temperature conditions may be prevented.

The thermal initiator may promote the crosslinking reaction of the epoxy siloxane resin or the crosslinking agent described later when heat is applied to the composition for forming a hard coating layer. As the thermal initiator, a cationic thermal initiator may be used, but the present disclosure is not necessarily limited thereto.

In addition, by using photocuring using the photoinitiator in combination with the thermal curing using the thermal initiator, the curing degree, the hardness, the flexibility, and the like of the hard coating layer may be improved. For example, the composition for forming a hard coating layer is applied to a substrate and is irradiated with ultraviolet rays (photocuring) to at least partially cure the composition, and then heat is further applied (thermal curing), thereby substantially completely curing the composition.

The composition for forming a hard coating layer may be semi-cured or partially cured by the photocuring, and the semi-cured or partially cured composition for forming a hard coating layer may be substantially completely cured by the thermal curing.

For example, when the composition for forming a hard coating layer is cured only by the photocuring, a curing time is excessively extended or curing may not be completely performed in part. However, when the photocuring is followed by the thermal curing, the portion which is not cured by the photocuring may be substantially completely cured by the thermal curing, and the curing time may be also reduced.

In addition, generally, a portion which has been already appropriately cured is provided with excessive energy due to an increased curing time (for example, an increased light exposure time), thereby causing overcuring. When the overcuring proceeds, the hard coating layer loses flexibility or mechanical defects such as curls or cracks may occur. However, when the photocuring and the thermal curing are used in combination, the composition for forming a hard coating layer may be substantially completely cured within a short time and the hardness of the hard coating layer may be further improved while the flexibility of the hard coating layer is maintained.

Though the method of first photocuring and then further thermally curing the composition for forming a hard coating layer has been described above, the sequence of the photocuring and the thermal curing is not particularly limited thereto. That is, in some exemplary embodiments, the thermal curing may be first performed and then the photocuring may be performed, of course.

In an embodiment, the thermal initiator may be included at 0.1 to 20 parts by weight, and more specifically 1 to 20 parts by weight with respect to 100 parts by weight of the condensate of an alkoxysilane having an epoxy group, but the present disclosure is not necessarily limited thereto. When the content of the thermal initiator is within the above range, the thermal curing reaction may proceed at a more effective speed, and the contents of other components of the composition for forming a hard coating layer are decreased, thereby preventing the mechanical properties (for example, hardness, flexibility, and curling properties) of the hard coating layer from being deteriorated.

In addition, for example, the thermal initiator may be included at 0.01 to 15 parts by weight, specifically 0.1 to 15 parts by weight, and more specifically 0.3 to 10 parts by weight with respect to a total of 100 parts by weight of the composition for forming a hard coating layer, but is not necessarily limited thereto.

In an embodiment, a photo-cationic initiator may be included. The photo-cationic initiator may initiate polymerization of the epoxy siloxane resin and an epoxy-based monomer.

As the photo-cationic initiator, an onium salt and/or an organic metal salt may be used, and for example, a diaryliodonium salt, triarylsulfonium salt, an aryldiazonium salt, and an iron-arene composite may be used alone or in combination of two or more, but the present disclosure is not necessarily limited thereto. The content of the photoinitiator is not particularly limited, but for example, the photoinitiator may be included at 0.1 to 15 parts by weight, specifically 1 to 15 parts by weight with respect to 100 parts by weight of the condensate of an alkoxysilane having an epoxy group, but is not necessarily limited thereto. When the content of the photoinitiator is within the above range, better curing efficiency of the composition for forming a hard coating layer may be maintained, and deterioration of the physical properties due to residual components after curing may be prevented.

In addition, for example, the photoinitiator may be included at 0.01 to 10 parts by weight, specifically 0.1 to 10 parts by weight, and more specifically 0.3 to 5 parts by weight with respect to a total of 100 parts by weight of the composition for forming a hard coating layer, but is not necessarily limited thereto.

In an embodiment, the composition for forming a hard coating layer may further include a crosslinking agent. For example, the crosslinking agent may form crosslinks with the condensate of an alkoxysilane having an epoxy group to solidify the composition for forming a hard coating layer and improve the hardness of the hard coating layer.

In an embodiment, the crosslinking agent may include a compound having an alicyclic epoxy group. For example, the crosslinking agent may include a compound in which two 3,4-epoxycyclohexyl groups are connected to each other, but is not necessarily limited thereto. The crosslinking agent may have a similar structure and a similar nature to the condensate of an alkoxysilane having an epoxy group, and in this case, the crosslinking agent may promote the crosslinking of the condensate of an alkoxysilane having an epoxy group and maintain an appropriate viscosity of the composition.

The content of the crosslinking agent is not particularly limited, and for example, may be 5 to 150 parts by weight with respect to 100 parts by weight of the condensate of an alkoxysilane having an epoxy group, but is not necessarily limited thereto. When the content of the crosslinking agent is within the above range, the viscosity of the composition may be maintained in an appropriate range, and applicability and curing reactivity may be more improved.

In addition, for example, the crosslinking agent may be included at 1 to 30 parts by weight, specifically 5 to 20 parts by weight with respect to a total of 100 parts by weight of the composition for forming a hard coating layer, but is not necessarily limited thereto.

In an embodiment, the composition for forming a hard coating layer may further include a thermal curing agent.

The thermal curing agent may include amine-based, imidazole-based, acid anhydride-based, and amide-based thermal curing agents, and more preferably, an acid anhydride-based thermal curing agent may be further used in terms of discoloration prevention and high hardness implementation, and these may be used alone or in combination of two or more, but the present disclosure is not necessarily limited thereto.

The content of the thermal curing agent is not particularly limited, and for example, may be 5 to 30 parts by weight with respect to 100 parts by weight of the condensate of an alkoxysilane having an epoxy group, but is not necessarily limited thereto. When the content of the thermal curing agent is within the above range, the hardness efficiency of the composition for forming a hard coating layer may be further improved to form a hard coating layer having better hardness.

In an embodiment, the composition for forming a hard coating layer may further include a solvent. The solvent is not particularly limited and a solvent known in the art may be used. A non-limiting example of the solvent may include alcohol-based solvents (such as methanol, ethanol, isopropanol, butanol, methyl cellosolve, and ethyl cellosolve), ketone-based solvents (such as methyl ethyl ketone, methyl butyl ketone, methyl isobutyl ketone, diethyl ketone, dipropyl ketone, and cyclohexanone), hexane-based solvents (such as hexane, heptane, and octane), and benzene-based solvents (such as benzene, toluene, and xylene). These may be used alone or in combination of two or more.

The content of the solvent is not particularly limited, and for example, may be 10 to 200 parts by weight, based on 100 parts by weight of the condensate of an alkoxysilane having an epoxy group. When the above range is satisfied, the composition for forming a hard coating layer may secure an appropriate level of viscosity, and thus, workability at the time of forming the hard coating layer may be better. In addition, it is easy to adjust the thickness of the hard coating layer, and the solvent drying time is reduced, whereby a more rapid process speed may be secured.

In an embodiment, the solvent may be included at a residual amount excluding the amount of the remaining components in the total weight of a predetermined entire composition. For example, when the total weight of the predetermined entire composition is 100 g and the sum of the weights of the components other than the solvent is 70 g, 30 g of the solvent may be included, but the present disclosure is not necessarily limited thereto.

In an embodiment, the composition for forming a hard coating layer may further include an inorganic filler. The inorganic filler may further improve the hardness of the hard coating layer.

The inorganic filler is not particularly limited, and an example thereof may include metal oxides such as silica, alumina, and titanium oxide; hydroxides such as aluminum hydroxide, magnesium hydroxide, and potassium hydroxide; metal particles such as gold, silver, bronze, nickel, and alloys thereof; conductive particles such as carbon, carbon nanotubes, and fullerene; glass; and ceramic; and, preferably, in terms of compatibility with other components of the composition for forming a hard coating layer, silica may be used, and these may be used alone or in combination of two or more, but the present disclosure is not necessarily limited thereto.

In an embodiment, the composition for forming a hard coating layer may further include a lubricant. The lubricant may further improve winding efficiency, blocking resistance, wear resistance, and scratch resistance.

The kind of lubricant is not particularly limited, and for example, waxes such as polyethylene wax, paraffin wax, synthetic wax, or montan wax; and synthetic resins such as silicon-based resins and fluorine-containing resins may be used, and these may be used alone or in combination of two or more, but the present disclosure is not necessarily limited thereto.

Besides, the composition for forming a hard coating layer may further include additives such as, for example, an antioxidant, a UV absorber, a photostabilizer, a thermal polymerization inhibitor, a leveling agent, a surfactant, a lubricant, and an antifouling agent.

### <Antifouling layer>

Next, the antifouling layer according to an embodiment will be described.

In an embodiment, the antifouling layer may be formed on the adhesion enhancement layer, and for example, the antifouling layer may be formed in contact with the upper surface of the adhesion enhancement layer.

In an embodiment, the antifouling layer may be formed by including a fluorine-containing alkoxysilane compound. The fluorine-containing alkoxysilane compound may be an alkoxysilane compound in which a silicon atom is directly substituted with fluorine or a substituent substituted on a silicon atom (for example, an alkyl group) is substituted with fluorine. That is to say, it may be a compound in which a fluorine-substituted alkyl group is connected to a silicon atom, but is not necessarily limited thereto.

More specifically, in an embodiment, the fluorine-containing alkoxysilane compound may have a perfluoropolyether group in a molecular main chain and a hydrolysable group bonded to a terminal silicon, but the present disclosure is not necessarily limited thereto. In this case, the hydrolysable reactive group may form a chemical bond with a reactive group of an alkoxysilane compound included in the adhesion enhancement layer by a hydrolysis reaction, or a condensation reaction, thereby further improving an interlayer binding force, and a fluorine functional group may be oriented on an upper layer of the surface of the antifouling layer to further improve antifouling properties, water repellency, and oil repellency.

In an embodiment, the perfluoropolyether group may include a perfluorinated repeating unit selected from -(CₚF₂ₚ)-, -(CₚF₂ₚO)-, -(CF(Z))-, -(CF(Z)O)-, -(CF(Z)CₚF₂ₚO)-, -(CₚF₂ₚCF(Z)O)-, - (CF₂CF(Z)O)-, or a combination thereof, may be linear, branched, cyclic, or a combination thereof, and may be saturated or unsaturated, but is not necessarily limited thereto.

In the repeating unit, p may be an integer of 1 to 10, specifically an integer of 1 to 4, more specifically an integer of 1 or 2, but is not necessarily limited thereto.

In addition, Z may be any one selected from a fluorine group, a perfluoroalkyl group, a perfluoroether group, a nitrogen-containing perfluoroalkyl group, a perfluoropolyether group, and a perfluoroalkoxy group, which may be all linear, branched, or cyclic, but the present disclosure is not necessarily limited thereto.

In addition, in the perfluoropolyether group, the number of the repeating units may be, independently of each other, 0 to 200, specifically 1 to 200, and the sum of the number of the repeating units may be at least one, specifically 20 to 100, and more specifically 30 to 50, but is not necessarily limited thereto, and in the perfluoropolyether group, the order of the repeating units may be arbitrary, which is not particularly limited.

A commercialized example of the fluorine-containing alkoxysilane compound may include KY-1901 and KY-19012 available from Shin-etsu, Optool DSX and UD120 available from Daikin, but which are only a non-limiting example, and the present disclosure is not necessarily limited thereto.

The antifouling layer formed by including the fluorine-containing alkoxysilane compound is formed on the adhesion enhancement layer formed by including the alkoxysilane compound having one or two or more functional groups, due to the similar chemical structure of each alkoxysilane compound included in the antifouling layer and the adhesion enhancement layer, the interlayer binding force may be further improved by the chemical bond between the antifouling layer and the adhesion enhancement layer.

In addition, the fluorine-containing alkoxysilane compound may impart excellent water repellent, water proof, and oil repellent functions to the antifouling layer. Therefore, the antifouling layer formed by including the fluorine-containing alkoxysilane compound may show excellent antifouling properties. In addition, the antifouling layer may have a water contact angle of 105° or more and may have properties such as excellent hardness, improved wear resistance, scratch resistance, and fingerprint wipeability.

In an embodiment, the antifouling layer may have a thickness of 1 to 100 nm, more specifically 5 to 50 nm, but is not necessarily limited thereto. When the thickness of the antifouling layer is within the range, the antifouling layer may show better antifouling properties.

Hereinafter, a method of forming an antifouling layer will be described.

The antifouling layer is formed by preparing a composition for forming an antifouling layer, applying the composition on the adhesion enhancement layer, and curing the composition.

In an embodiment, the composition for forming an antifouling layer may include a fluorine-containing alkoxysilane compound, in which the fluorine-containing alkoxysilane compound may be those as described above for the antifouling layer.

In an embodiment, the composition for forming an antifouling layer may include a solvent, the solvent may be any one selected from hexafluoroxylene, hydrofluorocarbon, and hydrofluoroether, or a combination of two or more thereof, and a commercialized example of the solvent may include HFE-7500, 7200, and 7100 available from 3M, Vertrel XF available from duPont, ZEORORA H available from Nippon Zeon, but these are only a non-limiting example, and the present disclosure is not necessarily limited thereto.

In an embodiment, the antifouling layer may be formed by thermally curing the applied composition for forming an antifouling layer. When the antifouling layer is cured by thermal curing, not by photocuring, the hard coating layer and the adhesion enhancement layer on a lower surface of the antifouling layer may be prevented from being exposed to active energy rays (for example, ultraviolet rays) again, and in particular, the hard coating layer may be prevented from being exposed to light again to cause overcuring or yellowing.

In an embodiment, the thermal curing may be performed at a temperature of 50 to 200°C for 3 to 30 minutes or at a temperature of 100 to 200°C for 5 to 30 minutes, but is not necessarily limited thereto. Within the temperature range, the composition for forming an antifouling layer may be cured at a more effective speed, and occurrence of a side reaction between each component in the composition may be effectively prevented.

### <Adhesion enhancement layer>

Next, an adhesion enhancement layer according to an embodiment will be described.

In an embodiment, the adhesion enhancement layer may be formed on the hard coating layer, and for example, the adhesion enhancement layer may be formed in contact with the upper surface of the hard coating layer.

In an embodiment, the adhesion enhancement layer may be formed by including an alkoxysilane compound having one or two or more functional groups. The alkoxysilane compound having one or two or more functional groups is an alkoxysilane compound substituted with one or two or more functional groups, and for example, may be an alkoxysilane compound in which a silicon atom is directly substituted with the functional group or a substituent substituted on a silicon atom (for example, an alkyl group) is substituted with the functional group. That is to say, it may be a compound in which an alkyl group substituted with one or two or more functional groups is connected to a silicon atom, but is not necessarily limited thereto.

In an embodiment, the functional group may be an organofunctional group, and for example, the organofunctional group may be any one selected from a carboxyl group, an epoxy group, a mercapto group, an isocyanate group, and an amino group, or a combination thereof, but is not necessarily limited thereto. Since an alkoxysilane compound having an organofunctional group has both an alkoxysilane group which reacts with an inorganic material and an organofunctional group forming a chemical bond with an organic material in the molecule, it has an excellent ability to bond an organic material and an inorganic material and decreases the surface energy of an organic material to further increase adhesive strength with an inorganic material. In addition, the alkoxysilane compound having an organofunctional group may increase compatibility with other resins.

Therefore, when the alkoxysilane compound having one or two or more functional groups included in the adhesion enhancement layer has both the organofunctional group and an alkoxysilane group, the alkoxysilane compound included in the adhesion enhancement layer may form a chemical bond with both the condensate of an alkoxysilane having an epoxy group of the hard coating layer and the fluorine-containing alkoxysilane compound of the antifouling layer. In addition, when the adhesion enhancement layer is formed between the hard coating layer and the antifouling layer, an interlayer binding force between each layer is further significantly improved, so that each layer may be substantially integrated.

In particular, the alkoxysilane compound having one or two or more functional groups included in the adhesion enhancement layer and the fluorine-containing alkoxysilane compound included in the antifouling layer may form a chemical bond by a hydrolysis reaction between hydrolysable reactive groups, a condensation reaction, and the like, and in this case, a binding force between the adhesion enhancement layer and the antifouling layer may be further improved, but which is only a non-limiting example, and the present disclosure is not necessarily limited thereto.

Therefore, when the adhesion enhancement layer is formed between the hard coating layer and the antifouling layer, the window cover film according to an embodiment may have a significantly improved interlayer binding force between each layer, have significantly improved wear resistance, scratch resistance, and fingerprint wipeability, and also implement a significantly improved sense of touch and surface properties such as slip properties.

More specifically, when the adhesion enhancement layer is formed between the hard coating layer and the antifouling layer, the window cover film according to an embodiment has significantly improved wear resistance, and may have a water contact angle of 90° or more in accordance with ASTM D5946 after evaluating wear resistance by rubbing 1500 times at a speed of 40 rpm against the surface of the window cover film at a distance of 20 mm with a load of 0.5 kg on a rubber stick (minoan) of a diameter of 6mm, but is not necessarily limited thereto.

In addition, the window cover film according to an embodiment may have a coefficient of dynamic friction of less than 0.15, as measured by rubbing a dust-free cloth with a force of 5 N with a load of 200 g at a speed of 100 mm/min, but is not necessarily limited thereto.

In addition, the window cover film according to an embodiment has significantly improved scratch resistance, so that no damage is shown on a film surface even after the surface is rubbed 1000 times reciprocatingly with steel wool with a load of 0.5 kg applied, and has significantly improved fingerprint wipeability, so that as a result of attaching a fingerprint on the surface of the antifouling layer of the film. wiping the surface with a dust-free cloth, and measuring the number of wipes until no fingerprint is observed, the number is less than 5 or 3 or less, but is not necessarily limited thereto.

In an embodiment, a commercialized example of the alkoxysilane compound having one or two or more functional groups may include KBM-402, KBM-603, KBM-903, and KBM-802 available from Shin-etsu, but which are only a non-limiting example, and the present disclosure is not necessarily limited thereto.

In an embodiment, the adhesion enhancement layer may have a thickness of 1 to 300 nm, more specifically 5 to 200 nm, but is not necessarily limited thereto. When the thickness of the adhesion enhancement layer is within the range, an interlayer binding force between each layer may be further improved, and the wear resistance, the scratch resistance, the fingerprint wipeability, and the like of the film may show better characteristics.

Hereinafter, a method of forming an adhesion enhancement layer will be described.

The adhesion enhancement layer is formed by preparing a composition for forming an adhesion enhancement layer, applying the composition on the hard coating layer, and drying the composition.

In an embodiment, the composition for forming an adhesion enhancement layer may include an alkoxysilane compound having one or two or more functional groups, in which the alkoxysilane compound having one or two or more functional groups may be those as described above for the adhesion enhancement layer.

In an embodiment, the composition for forming an adhesion enhancement layer may further include a solvent. The solvent is not particularly limited and a solvent known in the art may be used.

A non-limiting example of the solvent may include alcohol-based solvents (such as methanol, ethanol, isopropanol, butanol, methyl cellosolve, and ethyl cellosolve), and ketone-based solvents (such as methyl ethyl ketone, methyl butyl ketone, methyl isobutyl ketone, diethyl ketone, dipropyl ketone, and cyclohexanone). These may be used alone or in combination of two or more.

### <Flexible display panel>

Another embodiment may provide a flexible display panel or a flexible display device including the window cover film according to the embodiment.

Here, the window cover film may be used as a window substrate on the outermost surface of the flexible display device. The flexible display device may be various image display devices such as a common liquid crystal display device, an electroluminescent display device, a plasma display device, and a field emission display device.

### <Method of manufacturing window cover film>

Another embodiment provides a method of manufacturing the window cover film described above.

In an embodiment, the method of manufacturing a window cover film may include: applying a composition for forming a hard coating layer on one surface of a substrate layer and curing the composition to form a hard coating layer; applying a composition for forming an adhesion enhancement layer including an alkoxysilane compound having one or two or more functional groups on the hard coating layer and drying the composition to form an adhesion enhancement layer; and applying a composition for forming an antifouling layer including a fluorine-containing alkoxysilane compound on the adhesion enhancement layer and curing the composition to form an antifouling layer.

In addition, in an embodiment, the method of manufacturing a window cover film may further include applying the composition for forming a hard coating layer on the other surface of the substrate layer and curing the composition to form the hard coating layer.

In an embodiment, the application may be performed by a die coater, an air knife, a reverse roll, a spray, a blade, casting, gravure, and spin coating, but is not necessarily limited thereto.

In an embodiment, the step of forming a hard coating layer may be photocuring and then thermally curing the composition for forming a hard coating layer, but the present disclosure is not necessarily limited thereto.

Here, the thermal curing may be performed at a temperature of 100 to 200°C for 5 to 20 minutes, but is not necessarily limited thereto.

In addition, in an embodiment, before the photocuring, a step of heating the composition for forming a hard coating layer for pretreatment may be further included, and the pretreatment may be performed at a lower temperature than the thermal curing, but the present disclosure is not necessarily limited thereto.

In an embodiment, the step of drying the composition for forming an adhesion enhancement layer may be drying the composition for forming an adhesion enhancement layer at a temperature of 0 to 50°C for 3 to 10 minutes, but the present disclosure is not necessarily limited thereto.

In an embodiment, the step of curing the composition for forming an antifouling layer may be performed at a temperature of 50 to 200°C for 3 to 30 minutes or at a temperature of 100 to 200°C for 5 to 30 minutes, but the present disclosure is not necessarily limited thereto.

In the method of manufacturing a window cover film according to an embodiment, the substrate, the condensate of an alkoxysilane having an epoxy group, the composition for forming a hard coating layer, the composition for forming an adhesion enhancement layer, and the composition for forming an antifouling layer may be those as described above, and thus, the detailed descriptions thereof will be omitted herein. Hereinafter, the implementation will be described in more detail with reference to the examples and the comparative examples. However, the following examples and comparative examples are only an example for describing the implementation in more detail, and the implementation is not limited by the examples and the comparative examples.

### [Method of measuring physical properties]

### (1) Water contact angle

A contact angle was measured using a water contact angle measurer (Kruss, DSA) in accordance with the specification of ASTM D5946.

### (2) Rubber stick and wear resistance

Films manufactured in the following examples and comparative examples were cut into 7 cm × 12 cm and fixed to the jig of a wear resistance meter (Kipae E&T Co., Ltd., scratch tester), and a rubber stick having a diameter of 6 mm (Minoan) was mounted on and fixed to the tip. A moving distance of 25mm, a moving speed of 40 rpm, and a load of 0.5 kg were set, the rubber stick was rubbed 1500 times reciprocatingly on the surface of the antifouling layer of the films, and then the water contact angle of the worn surface was measured by the measurement method of a water contact angle.

### (3) Coefficient of dynamic friction

The films manufactured in the following examples and comparative examples were cut into 7 cm × 12 cm and fixed to a friction tester (TOYOSEIKI, TR-2), and measurement was performed with a distance of 100 mm at a speed of 100 mm/min, with a force of 5 N with a load of 200 g, using a dust-free cloth as a material to be rubbed.

### (4) Scratch resistance

Films manufactured in the following examples and comparative examples were cut into 7 cm × 12 cm and fixed to the jig of a wear resistance meter (Kipae E&T Co., Ltd.), and steel wool (#0000, Leberon Limited) was mounted on and fixed to the tip having a diameter of 22 mm. A moving distance of 40mm, a moving speed of 40 rpm, and a load of 0.5 kg were set, the steel wool was rubbed against the surface of the antifouling layer of the film 1000 times reciprocatingly, and whether there are flaws (scratches) on the surface was visually observed. After observation, it was determined to be "OK" when there was no damage, and "NG" when damage occurred.

### (5) Fingerprint wipeability

A fingerprint was attached on the surface of the antifouling layer of the films manufactured in the following examples and comparative examples, the surface was wiped with a dust-free cloth, and the number of wipes until no fingerprint was observed was measured.

### [Preparation of composition for forming hard coating layer]

### [Preparation Example 1]

2-(3,4-epoxycyclohexyl)ethyltrimethoxysilane (ECTMS, TCI) and water were mixed at a ratio of 24.64 g: 2.70 g (0.1 mol: 0.15 mol) to prepare a reaction solution which was added to a 250 mL 2-neck flask. 0.1 mL of a tetramethylammonium hydroxide catalyst (Aldrich) and 100 mL of tetrahydrofuran (Aldrich) were added to the mixture and stirring was performed at 25°C for 36 hours.

Thereafter, layer separation was performed, a product layer was extracted with methylene chloride (Aldrich), moisture was removed from the extract with magnesium sulfate (Aldrich), and the solvent was dried under vacuum to obtain an epoxy siloxane-based resin. The weight average molecular weight of the epoxy siloxane-based resin was measured using gel permeation chromatography (GPC), and the result was 2,500 g/mol.

30 g of the epoxy siloxane-based resin as prepared above, 10 g of (3',4'-epoxycyclohexyl)methyl 3,4-epoxycyclohexane carboxylate and 5 g of bis[(3,4-epoxycyclohexyl)methyl] adipate as a crosslinking agent, 0.5 g of (4-methylphenyl)[4-(2-methylpropyl)phenyl]iodoniumhexafluorophosphate as a photoinitiator, 0.1 g of 4-acetoxyphenyldimethylsulfonium hexafluoroantimonate as a thermal initiator, and 54.5 g of methylethyl ketone were mixed, thereby preparing a composition for forming a hard coating layer.

### [Preparation of composition for forming antifouling layer]

### [Preparation Example 2]

An alkoxysilane compound containing a perfluorinated group and an alkoxysilane group (Shin-etsu, KY-1905) was diluted with a fluorine-containing solvent (3M, Novec 7500) so that a solid content was 0.1 wt%, thereby preparing a composition for forming an antifouling layer.

### [Preparation of composition for forming adhesion enhancement layer]

### [Preparation Example 3]

An alkoxysilane compound containing an epoxy group and an alkoxysilane group (Shin-etsu, KBM-402) was diluted with an ethanol solution so that a solid content was 0.1 wt%, thereby preparing a composition for forming an adhesion enhancement layer.

### [Preparation Example 4]

0.6 g of 3-aminopropyltrimethoxysilane, 0.4 g of bis [3-trimethoxysilyl]propylamine, and 11 ml of 2-propanol were added to a 25 ml flask, and the flask was heated to 60°C. After sufficient stirring, the mixture was cooled to room temperature, 0.081 g of distilled water was added, and stirring was performed at room temperature for 3 days, thereby obtaining 9.73 g of an alkoxysilane compound containing an amino group and an alkoxysilane group. The alkoxysilane compound was diluted with an isopropanol solution so that a solid content was 0.1 wt%, thereby preparing a composition for forming an adhesion enhancement layer.

### [Preparation Example 5]

An alkoxysilane compound containing an amino group and an alkoxysilane group (Shin-etsu, KBM-603) was diluted with an ethanol solution so that a solid content was 0.1 wt%, thereby preparing a composition for forming an adhesion enhancement layer.

### [Preparation Example 6]

An alkoxysilane compound containing a mercapto group and an alkoxysilane group (Shin-etsu, KBM-802) was diluted with an ethanol solution so that a solid content was 0.1 wt%, thereby preparing a composition for forming an adhesion enhancement layer.

### [Manufacture of window cover film]

### [Example 1]

### Manufacture of substrate layer

In a reactor under a nitrogen atmosphere, terephthaloyl dichloride (TPC) and 2,2'-bis(trifluoromethyl)-benzidine (TFMB) were added to a mixed solution of dichloromethane and pyridine, and stirring was performed at 25°C for 2 hours under a nitrogen atmosphere. At this time, TPC and TFMB were introduced at a mole ratio of 3:4, the solid content was adjusted to 10 wt%, and polymerization was performed. Thereafter, the product was precipitated in an excessive amount of methanol and filtered to obtain a solid content, which was dried under vacuum at 50°C for 6 hours or more to obtain an oligomer, and the prepared oligomer had a formula weight (FW) of 1670 g/mol.

N,N-dimethylacetamide (DMAc) as a solvent, 100 mol of the oligomer, and 28.6 mol of 2,2'-bis(trifluoromethyl)-benzidine (TFMB) were introduced to the reactor and sufficient stirring was performed. Thereafter, 64.3 mol of cyclobutanetetracarboxylic dianhydride (CBDA) and 64.3 mol of 4,4'-hexafluoroisopropylidene diphthalic anhydride (6FDA) were introduced to the reactor, sufficient stirring was performed, and polymerization was performed at 40°C for 10 hours. At this time, the solid content of the reaction solution was 20 wt%. Subsequently, each of pyridine and acetic anhydride was added to the reaction solution sequentially at 2.5-fold to the total content of dianhydride, and stirring was performed at 60 °C for 12 hours.

After the polymerization was completed, the polymerization solution was precipitated in an excessive amount of methanol and filtered to obtain a solid content, which was dried under vacuum at 50°C for 6 hours or more, thereby obtaining polyamideimide powder. The powder was diluted and dissolved at 20 wt% in DMAc to prepare a composition for forming a substrate layer.

The composition for forming a substrate layer was applied on a support (glass substrate) using an applicator, dried at 80°C for 30 minutes and 100°C for 1 hour, and cooled to room temperature to manufacture a film. Thereafter, a stepwise heat treatment at 100 to 200°C for 120 minutes and 250 to 300°C for 48 minutes (40% of a total heat treatment time) at a heating rate of 20°C/min was performed to manufacture a substrate layer. At this time, the thickness of the substrate layer was 50 µm.

### Formation of hard coating layer

The composition for forming a hard coating layer prepared in Preparation Example 1 was applied on one surface of the substrate layer manufactured above using a meyer bar, and dried at a temperature of 60°C for 4 minutes. Thereafter, UV rays were irradiated at 1 J/cm² using a high pressure metal lamp, and curing was performed at a temperature of 120°C for 10 minutes, thereby forming a hard coating layer. At this time, the thickness of the hard coating layer was 5 µm.

### Formation of adhesion enhancement layer

The composition for forming an adhesion enhancement layer prepared in Preparation Example 3 was applied on the hard coating layer using a meyer bar #14, and dried at room temperature for 5 minutes to form an adhesion enhancement layer. At this time, the thickness of the adhesion enhancement layer was 32 nm.

### Formation of antifouling layer

The composition for forming an antifouling layer prepared in Preparation Example 2 was applied on the adhesion enhancement layer using a meyer bar #14, dried at 80°C for 5 minutes, and then thermally cured at 150°C for 10 minutes, thereby manufacturing a window cover film having an antifouling layer (thickness: 32 nm) formed thereon.

### [Example 2]

A window cover film was manufactured in the same manner as in Example 1, except that the adhesion enhancement layer was formed using the composition for forming an adhesion enhancement layer prepared in Preparation Example 4 instead of the composition for forming an adhesion enhancement layer prepared in Preparation Example 3.

### [Example 3]

A window cover film was manufactured in the same manner as in Example 1, except that the adhesion enhancement layer was formed using the composition for forming an adhesion enhancement layer prepared in Preparation Example 5 instead of the composition for forming an adhesion enhancement layer prepared in Preparation Example 3.

### [Example 4]

A window cover film was manufactured in the same manner as in Example 1, except that the adhesion enhancement layer was formed using the composition for forming an adhesion enhancement layer prepared in Preparation Example 6 instead of the composition for forming an adhesion enhancement layer prepared in Preparation Example 3.

### [Comparative Example 1]

A window cover film was manufactured in the same manner as in Example 1, except that the step of forming an adhesion enhancement layer was omitted, and the composition for forming an antifouling layer prepared in Preparation Example 2 was applied on the hard coating layer and cured to form an antifouling layer.

### [Comparative Example 2]

A hard coating layer was formed on a substrate layer in the same manner as in Example 1, using the composition for forming a hard coating layer in which 0.2 g of a water repellent additive (Shin-etsu, KY-1271) was further added to the composition for forming a hard coating layer prepared in Preparation Example 1, thereby manufacturing a window cover film having no adhesion enhancement layer or antifouling layer separately.The physical properties of the window cover films manufactured in Examples 1 to 4 and Comparative Examples 1 and 2 were measured and are shown in the following Table 1.

**[Table 1]**

| | Water contact angle (°) | Rubber stick wear resistance (°) | Coefficient of dynamic friction | Scratch resistance | Fingerprint wipeability |
|---|---|---|---|---|---|
| Example 1 | 109 | 97 | 0.10 | OK | 3 times |
| Example 2 | 110 | 100 | 0.09 | OK | 3 times |
| Example 3 | 111 | 97 | 0.09 | OK | 3 times |
| Example 4 | 110 | 97 | 0.08 | OK | 3 times |
| Comparative Example 1 | 109 | 84 | 0.15 | NG | 5 times |
| Comparative Example 2 | 106 | 80 | 0.19 | NG | 9 times |

Referring to Table 1, the window cover films of Examples 1 to 4 on which the adhesion enhancement layer manufactured by including an alkoxysilane compound having a functional group between the hard coating layer and the antifouling layer was formed had excellent antifouling properties with the water contact angle of 105° or more or 110° or more, and, in particular, had excellent wear resistance with the water contact angle measured after rubber stick wear resistance evaluation of 95° or more.

In addition, as a result of measuring the coefficient of dynamic friction, it was confirmed that the coefficient of dynamic friction was less than 0.15 in all examples to show excellent fingerprint resistance, and also, a significantly improved sense of touch and surface properties such as slip properties may be implemented.

In addition, as a result of scratch resistance evaluation, no damage occurred on the appearance of the film to show excellent scratch resistance, as a result of fingerprint wipeability evaluation, the number of wipes with dust-free cloth until no fingerprint was observed was measured to be 3 times, so that the fingerprint on the surface may be removed only with the very small number of wipes, and thus, excellent fingerprint wipeability was also confirmed.

However, the window cover film of Comparative Example 1 having no adhesion enhancement layer formed between the hard coating layer and the antifouling layer and the window cover film of Comparative Example 2 in which the separate antifouling layer and adhesion enhancement layer were not formed and simply a water repellent additive was included in the hard coating layer had a greatly lowered water contact angle as measured after the rubber stick wear resistance evaluation, and a high coefficient of dynamic friction as compared with all of the examples, and thus, greatly lowered surface properties were confirmed.

In addition, as a result of scratch resistance evaluation, it was confirmed that significant damage on the surface was shown, and as a result of fingerprint wipeability evaluation, the number of wipes with a dust-free cloth until no fingerprint was observed was observed to be 5 times or more, and in particular 9 times in Comparative Example 2, and thus, significantly lowered fingerprint wipeability as compared with Examples 1 to 4 was confirmed.

Therefore, according to an implementation, the window cover film in which the adhesion enhancement layer manufactured by including the alkoxysilane compound having one or two or more functional groups is formed between the hard coating layer and the antifouling layer may have a significantly improved interlayer binding force between each layer, may be not easily damaged even by the exposure to abrasion, vibration, compounds, and the like, so that surface properties such as wear resistance, scratch resistance, and fingerprint wipeability are significantly improved to minimize damage or staining on the appearance, may have a glass-like sense of touch, and may have excellent slip properties.

An embodiment of the present disclosure provides a window cover film and a flexible display panel including the same, and the window cover film includes an adhesion enhancement layer manufactured by including an alkoxysilane compound having one or two or more functional groups, thereby significantly improving an interlayer binding force.

In addition, the window cover film according to an embodiment may not be easily damaged even by exposure to abrasion, vibration, compounds, and the like.

In addition, the window cover film according to an embodiment may satisfy a water contact angle of 90° or more even after long-term wear resistance evaluation and may have significantly improved wear resistance.

In addition, the window cover film according to an embodiment may have a glass-like sense of touch and excellent surface properties of excellent slip properties.

In addition, the window cover film according to an embodiment has excellent scratch resistance and fingerprint wipeability and may minimize damage or staining of an appearance of a film surface.

As described above, implementations have been described by the specified matters and the defined examples in the present specification, but are only provided for helping the overall understanding of the implementations, and the implementations are not limited to the examples. The invention is defined in the appended claims.

## Claims

1. A window cover film comprising:
a substrate layer;
a hard coating layer formed on one surface of the substrate layer;
an adhesion enhancement layer formed from a composition for forming an adhesion enhancement layer comprising an alkoxysilane compound having one or two or more functional groups, formed on the hard coating layer; and
an antifouling layer formed from a composition for forming an antifouling layer layer comprising a fluorine-containing alkoxysilane compound, formed on the adhesion enhancement layer.

2. The window cover film of claim 1, wherein the functional group is an organofunctional group, preferably the organofunctional group is any one selected from a carboxyl group, an epoxy group, a mercapto group, an isocyanate group, and an amino group, or a combination thereof.

3. The window cover film of any of claims 1 or 2, wherein the fluorine-containing alkoxysilane compound has a perfluoropolyether group in a molecular main chain and a hydrolysable group bonded to a terminal silicon.

4. The window cover film of any of claims 1 to 3, wherein the window cover film has a water contact angle of 90° or more in accordance with ASTM D5946 after evaluating wear resistance by rubbing 1500 times at a speed of 40 rpm against the surface of the window cover film at a distance of 25 mm with a load of 0.5 kg on a rubber stick (minoan) of a diameter of 6 mm utilizing the procedure and equipment as described in the description.

5. The window cover film of any of claims 1 to 4, wherein the film has a coefficient of dynamic friction of less than 0.15, as measured by rubbing a dust-free cloth with a force of 5 N with a load of 200 g at a speed of 100 mm/min utilizing the procedure and equipment as described in the description.

6. The window cover film of any of claims 1 to 5, wherein the hard coating layer is formed from a composition for forming a hard coating layer comprising a condensate of an alkoxysilane having an epoxy group.

7. The window cover film of claim 6, wherein the condensate of an alkoxysilane having an epoxy group is a silsesquioxane resin having an epoxy group.

8. The window cover film of claim 6, wherein the hard coating layer is formed by further including a crosslinking agent having a polyfunctional epoxy group.

9. The window cover film of any of claims 1 to 8, wherein the substrate layer is a polyimide-based substrate layer including a unit derived from a fluorine-containing aromatic diamine, preferably the substrate layer is a polyimide-based substrate layer including a unit derived from a fluorine-containing aromatic diamine, a unit derived from an aromatic dianhydride, and a unit derived from an aromatic diacid dichloride, preferably the polyimide-based substrate layer further includes a unit derived from a cycloaliphatic dianhydride.

10. The window cover film of any of claims 1 to 9, wherein a thickness of the substrate layer is 10 to 150 µm; and/or a thickness of the hard coating layer is 1 to 100 µm; and/or a thickness of the antifouling layer is 1 to 100 nm; and/or a thickness of the adhesion enhancement layer is 1 to 300 nm.

11. A method of manufacturing a window cover film, the method comprising:
applying a composition for forming a hard coating layer on one surface of a substrate layer and curing the composition to form a hard coating layer;
applying a composition for forming an adhesion enhancement layer including an alkoxysilane compound having one or two or more functional groups on the hard coating layer and drying the composition to form an adhesion enhancement layer; and
applying a composition for forming an antifouling layer including a fluorine-containing alkoxysilane compound on the adhesion enhancement layer and curing the composition to form an antifouling layer.

12. The method of manufacturing a window cover film of claim 11, wherein the functional group is an organofunctional group, preferably the organofunctional group is any one selected from a carboxyl group, an epoxy group, a mercapto group, an isocyanate group, and an amino group, or a combination thereof.

13. The method of manufacturing a window cover film of claim 11, wherein the fluorine-containing alkoxysilane compound has a perfluoropolyether group in a molecular main chain and a hydrolysable group bonded to a terminal silicon.

14. The method of manufacturing a window cover film of claim 11, wherein the composition for forming a hard coating layer includes a condensate of an alkoxysilane having an epoxy group, preferably the condensate of an alkoxysilane having an epoxy group is a silsesquioxane resin having an epoxy group, preferably the composition for forming a hard coating layer further includes a crosslinking agent having a polyfunctional epoxy group.

15. A flexible display panel comprising the window cover film according to any of claims 1 to 10.

## Patentansprüche

1. Fensterabdeckfolie, bestehend aus:
einer Substratschicht;
einer harten Überzugsschicht, die auf einer Oberfläche der Substratschicht gebildet wird;
einer Haftungsverstärkungsschicht, die aus einer Zusammensetzung zur Bildung einer Haftungsverstärkungsschicht gebildet wird, die eine Alkoxysilanverbindung mit einer oder zwei oder mehreren funktionellen Gruppen umfasst, die auf der harten Beschichtungsschicht gebildet wird; und
einer anwuchsverhindernden Schicht, die aus einer Zusammensetzung zur Bildung einer anwuchsverhindernden Schicht gebildet wird, die eine fluorhaltige Alkoxysilanverbindung umfasst, die auf der Haftverbesserungsschicht gebildet wird.

2. Fensterabdeckfolie nach Anspruch 1, wobei die funktionelle Gruppe eine organofunktionelle Gruppe ist, vorzugsweise ist die organofunktionelle Gruppe eine beliebige Gruppe, ausgewählt aus einer Carboxylgruppe, einer Epoxygruppe, einer Mercaptogruppe, einer Isocyanatgruppe und einer Aminogruppe oder einer Kombination davon.

3. Fensterabdeckfolie nach einem der Ansprüche 1 oder 2, wobei die fluorhaltige Alkoxysilanverbindung eine Perfluorpolyethergruppe in einer molekularen Hauptkette und eine an ein endständiges Silicium gebundene hydrolysierbare Gruppe aufweist.

4. Fensterabdeckfolie nach einem der Ansprüche 1 bis 3, wobei die Fensterabdeckfolie einen Wasserkontaktwinkel von 90° oder mehr gemäß ASTM D5946 aufweist, nachdem die Abnutzungsbeständigkeit durch 1500-maliges Reiben bei einer Geschwindigkeit von 40 U/min gegen die Oberfläche der Fensterabdeckfolie in einem Abstand von 25 mm mit einer Last von 0,5 kg auf einem Gummistab (Minoan) mit einem Durchmesser von 6 mm unter Verwendung des Verfahrens und der Ausrüstung, wie in der Beschreibung dargelegt, bewertet wurde.

5. Fensterabdeckfolie nach einem der Ansprüche 1 bis 4, wobei die Folie einen dynamischen Reibungskoeffizienten von weniger als 0,15 aufweist, gemessen durch Reiben eines staubfreien Tuchs mit einer Kraft von 5 N und einer Last von 200 g bei einer Geschwindigkeit von 100 mm/min unter Verwendung des Verfahrens und der Ausrüstung wie in der Beschreibung beschrieben.

6. Fensterabdeckfolie nach einem der Ansprüche 1 bis 5, wobei die harte Überzugsschicht aus einer Zusammensetzung zur Bildung einer harten Überzugsschicht gebildet ist, die ein Kondensat eines Alkoxysilans mit einer Epoxygruppe umfasst.

7. Fensterabdeckfolie nach Anspruch 6, wobei das Kondensat eines Alkoxysilans mit einer Epoxygruppe ein Silsesquioxanharz mit einer Epoxygruppe ist.

8. Fensterabdeckfolie nach Anspruch 6, wobei die harte Überzugsschicht ferner durch Einschluss eines Vernetzungsmittels mit einer polyfunktionellen Epoxygruppe gebildet wird.

9. Fensterabdeckfolie nach einem der Ansprüche 1 bis 8, wobei die Substratschicht eine Substratschicht auf Polyimidbasis ist, die eine von einem fluorhaltigen aromatischen Diamin abgeleitete Einheit enthält, vorzugsweise ist die Substratschicht eine Substratschicht auf Polyimidbasis, die eine von einem fluorhaltigen aromatischen Diamin abgeleitete Einheit, eine von einem aromatischen Dianhydrid abgeleitete Einheit und eine von einem aromatischen Disäuredichlorid abgeleitete Einheit enthält, vorzugsweise enthält die Substratschicht auf Polyimidbasis ferner eine von einem cycloaliphatischen Dianhydrid abgeleitete Einheit.

10. Fensterabdeckfolie nach einem der Ansprüche 1 bis 9, wobei die Dicke der Substratschicht 10 bis 150 µm beträgt; und/oder die Dicke der harten Überzugsschicht 1 bis 100 µm beträgt; und/oder die Dicke der Antifouling-Schicht 1 bis 100 nm beträgt; und/oder die Dicke der Haftverbesserungsschicht 1 bis 300 nm beträgt.

11. Verfahren zur Herstellung einer Fensterabdeckfolie, wobei das Verfahren umfasst:
Aufbringen einer Zusammensetzung zur Bildung einer harten Überzugsschicht auf eine Oberfläche einer Substratschicht und Aushärten der Zusammensetzung zur Bildung einer harten Überzugsschicht;
Auftragen einer Zusammensetzung zur Bildung einer Haftverbesserungsschicht, die eine Alkoxysilanverbindung mit einer oder zwei oder mehreren funktionellen Gruppen enthält, auf die harte Überzugsschicht und Trocknen der Zusammensetzung zur Bildung einer Haftverbesserungsschicht; und
Aufbringen einer Zusammensetzung zur Bildung einer Antifouling-Schicht, die eine fluorhaltige Alkoxysilanverbindung enthält, auf die Haftverbesserungsschicht und Aushärten der Zusammensetzung zur Bildung einer Antifouling-Schicht.

12. Verfahren zur Herstellung einer Fensterabdeckfolie nach Anspruch 11, wobei die funktionelle Gruppe eine organofunktionelle Gruppe ist, vorzugsweise ist die organofunktionelle Gruppe eine beliebige Gruppe, ausgewählt aus einer Carboxylgruppe, einer Epoxygruppe, einer Mercaptogruppe, einer Isocyanatgruppe und einer Aminogruppe oder einer Kombination davon.

13. Verfahren zur Herstellung einer Fensterabdeckfolie nach Anspruch 11, wobei die fluorhaltige Alkoxysilanverbindung eine Perfluorpolyethergruppe in einer molekularen Hauptkette und eine an ein endständiges Silicium gebundene hydrolysierbare Gruppe aufweist.

14. Verfahren zur Herstellung einer Fensterabdeckfolie nach Anspruch 11, wobei die Zusammensetzung zur Bildung einer harten Überzugsschicht ein Kondensat eines Alkoxysilans mit einer Epoxygruppe enthält, vorzugsweise ist das Kondensat eines Alkoxysilans mit einer Epoxygruppe ein Silsesquioxanharz mit einer Epoxygruppe, vorzugsweise enthält die Zusammensetzung zur Bildung einer harten Überzugsschicht außerdem ein Vernetzungsmittel mit einer polyfunktionellen Epoxygruppe.

15. Flexible Anzeigetafel, die die Fensterabdeckfolie nach einem der Ansprüche 1 bis 10 umfasst.

## Revendications

1. Film de protection des fenêtres comprenant une couche de substrat ;
une couche de revêtement dur formée sur une surface de la couche de substrat ;
une couche d'amélioration de l'adhérence formée à partir d'une composition pour former une couche d'amélioration de l'adhérence comprenant un composé alcoxysilane ayant un ou deux groupes fonctionnels ou plus, formée sur la couche de revêtement dur ; et
une couche antisalissure formée à partir d'une composition pour la formation d'une couche antisalissure comprenant un composé alcoxysilane contenant du fluor, formée sur la couche d'amélioration de l'adhérence.

2. Film de protection des fenêtres de la revendication 1, dans lequel le groupe fonctionnel est un groupe organofonctionnel, de préférence le groupe organofonctionnel est choisi parmi un groupe carboxyle, un groupe époxy, un groupe mercapto, un groupe isocyanate et un groupe amino, ou une combinaison de ceux-ci.

3. Film de protection des fenêtres de l'une des revendications 1 ou 2, dans lequel le composé alcoxysilane contenant du fluor possède un groupe perfluoropolyéther dans une chaîne moléculaire principale et un groupe hydrolysable lié à un silicium terminal.

4. Film de protection des fenêtres de l'une des revendications 1 à 3, dans lequel le film de protection des fenêtres a un angle de contact avec l'eau de 90° ou plus conformément à la norme ASTM D5946 après avoir évalué la résistance à l'usure en frottant 1500 fois à une vitesse de 40 tr/min contre la surface du film de protection des fenêtres à une distance de 25 mm avec une charge de 0,5 kg sur un bâton en caoutchouc (minoan) d'un diamètre de 6 mm en utilisant la procédure et l'équipement tels que décrits dans la description.

5. Film de protection des fenêtres de l'une des revendications 1 à 4, dans lequel le film a un coefficient de frottement dynamique inférieur à 0,15, mesuré en frottant un chiffon exempt de poussière avec une force de 5 N et une charge de 200 g à une vitesse de 100 mm/min en utilisant la procédure et l'équipement décrits dans la description.

6. Film de protection des fenêtres de l'une des revendications 1 à 5, dans lequel la couche de revêtement dur est formée à partir d'une composition pour former une couche de revêtement dur comprenant un condensat d'un alcoxysilane ayant un groupe époxy.

7. Film de protection des fenêtres selon la revendication 6, dans lequel le condensat d'un alcoxysilane à groupe époxy est une résine silsesquioxane à groupe époxy.

8. Film de protection des fenêtres de la revendication 6, dans lequel la couche de revêtement dur est formée par l'ajout d'un agent de réticulation ayant un groupe époxy polyfonctionnel.

9. Film de protection des fenêtres de l'une des revendications 1 à 8, dans lequel la couche de substrat est une couche de substrat à base de polyimide comprenant une unité dérivée d'une diamine aromatique fluorée, de préférence la couche de substrat est une couche de substrat à base de polyimide comprenant une unité dérivée d'une diamine aromatique fluorée, une unité dérivée d'un dianhydride aromatique, et une unité dérivée d'un dichlorure de diacide aromatique, de préférence la couche de substrat à base de polyimide comprend en outre une unité dérivée d'un dianhydride cycloaliphatique.

10. Film de protection des fenêtres de l'une des revendications 1 à 9, dans lequel une épaisseur de la couche de substrat est de 10 à 150 µm ; et/ou une épaisseur de la couche de revêtement dur est de 1 à 100 µm ; et/ou une épaisseur de la couche antisalissure est de 1 à 100 nm ; et/ou une épaisseur de la couche d'amélioration de l'adhérence est de 1 à 300 nm.

11. Procédé de fabrication d'un film de recouvrement de fenêtre, comprenant les opérations suivantes
appliquer une composition pour former une couche de revêtement dur sur une surface d'une couche de substrat et durcir la composition pour former une couche de revêtement dur ;
appliquer une composition pour former une couche d'amélioration de l'adhérence comprenant un composé alcoxysilane ayant un ou deux groupes fonctionnels ou plus sur la couche de revêtement dur et sécher la composition pour former une couche d'amélioration de l'adhérence ; et
appliquer une composition pour former une couche antisalissure comprenant un composé alcoxysilane contenant du fluor sur la couche d'amélioration de l'adhérence et durcir la composition pour former une couche antisalissure.

12. Procédé de fabrication d'un film de recouvrement de fenêtre selon la revendication 11, dans lequel le groupe fonctionnel est un groupe organofonctionnel, de préférence le groupe organofonctionnel est choisi parmi un groupe carboxyle, un groupe époxy, un groupe mercapto, un groupe isocyanate et un groupe amino, ou une combinaison de ceux-ci.

13. Procédé de fabrication d'un film de recouvrement de fenêtre selon la revendication 11, dans lequel le composé alcoxysilane contenant du fluor possède un groupe perfluoropolyéther dans une chaîne moléculaire principale et un groupe hydrolysable lié à un silicium terminal.

14. Procédé de fabrication d'un film de recouvrement de fenêtre de la revendication 11, dans lequel la composition pour former une couche de revêtement dur comprend un condensat d'un alcoxysilane ayant un groupe époxy, de préférence le condensat d'un alcoxysilane ayant un groupe époxy est une résine silsesquioxane ayant un groupe époxy, de préférence la composition pour former une couche de revêtement dur comprend en outre un agent de réticulation ayant un groupe époxy polyfonctionnel.

15. Panneau d'affichage flexible comprenant le film de recouvrement de fenêtre selon l'une des revendications 1 à 10.
